# EUROPÄISCHE PATENTSCHRIFT

(11) **EP 0 643 480 B1**
(45) Veröffentlichungstag und Bekanntmachung des Hinweises auf die Patenterteilung: **16.09.1998**
(21) Anmeldenummer: 94106034.5
(22) Anmeldetag: 19.04.1994
(51) Int. Cl.: H03G 3/34

(54) **Schaltungsanordnung zur Befreiung eines Multiplexsignals von Zündstörungen**
Impulse noise suppression circuit for a multiplex signal
Circuit pour supprimer des impulsions parasites présentes dans des signaux multiplexés

(30) Priorität: 11.09.1993 DE 4330892
(43) Veröffentlichungstag der Anmeldung: 15.03.1995
(73) Patentinhaber: Blaupunkt-Werke GmbH, D-31139 Hildesheim (DE)
(72) Erfinder: Chahabadi, Djahanyar, Dr., 23909 Ratzeburg (DE); Vogt, Lothar, Dr., D-31249 Hohenhameln (DE)

(56) Entgegenhaltungen:
- EP-A- 0 056 464
- DE-A- 2 807 600
- US-A- 4 574 390

## Beschreibung

Die Erfindung betrifft eine Schaltungsanordnung zur Befreiung eines Multiplexsignals von Zündstörungen in einem Rundfunkempfänger, vorzugsweise in einem Autoradio.

Solche Schaltungen sind aus dem Dokument EP-A-0 056 464 bekannt.

Zündfunken von Brennkraftmaschinen senden kurze Hochfrequenzimpulse innerhalb eines weiten Frequenzbereichs aus, die den Empfang von Rundfunksendungen empfindlich stören können. Bei Stereo-Rundfunkempfängern, die gegebenenfalls mit Einrichtungen zur Decodierung von Verkehrsfunk- und Radio-Daten-Signalen ausgerüstet sind, treten die Störungen in Form von kurzen Impulsen im Multiplexsignal auf. Bei den üblichen Analogschaltungen in Rundfunkempfängern ist es bekannt, bei Auftreten einer Zündstörung die zuvor vorhandene Amplitude des Audiosignals kurzzeitig beizubehalten. Dazu ist allerdings eine Entfernung des Pilottons aus dem Multiplexsignal erforderlich.

Aufgabe der vorliegenden Erfindung ist es, eine Schaltungsanordnung zur Befreiung des Multiplexsignals von Zündstörungen für digitale Rundfunkempfänger anzugeben, welche unter Ausnutzung der Möglichkeiten von digitalen Schaltungen die Störbefreiung am unveränderten Multiplexsignal vornehmen kann.

Dieses Aufgabe wird erfindungsgemäß dadurch gelöst, daß das Multiplexsignal als digitales Signal mit einer Abtastfrequenz von einem Vielfachen der Pilottonfrequenz über einen Hochpaß und eine Quadrierschaltung geleitet wird, daß das hochpaßgefilterte und quadrierte Multiplexsignal und ein zeitlicher Mittelwert des hochpaßgefilterten und quadrierten Multiplexsignals miteinander verglichen werden, daß bei Abweichungen, die größer als ein vorgegebenes Maß sind, ein Steuersignal vorgegebener Dauer gebildet wird und daß das Steuersignal eine Korrekturschaltung derart steuert, daß während des Steuersignals auftretende Abtastwerte des Multiplexsignals durch während der vorangegangenen Periode des Pilottons auftretende Abtastwerte ersetzt werden.

Die erfindungsgemäße Schaltungsanordnung hat den Vorteil, daß eine aufwendige Entfernung des Pilottons aus dem Multiplexsignal nicht erforderlich ist. Außerdem wird dadurch auch der Pilotton selbst von Zündstörungen befreit. Ferner wird in vorteilhafter Weise berücksichtigt, daß die Wirkung von Störsignalen - also auch Zündstörungen - proportional zur Leistung der empfangenen Störsignale ist.

Eine Ausführungsform der Erfindung besteht darin, daß die Quadrierschaltung aus einer Schaltung zur Betragsbildung besteht. Gemäß einer Weiterbildung ist vorgesehen, daß der zeitliche Mittelwert mit Hilfe eines Tiefpasses gebildet wird, dessen Grenzfrequenz im Bereich zwischen 100 Hz und 1000 Hz liegt. Dadurch können Zündstörungen von anderen, jedoch höherfrequenten Einflüssen, z. B. Mehrwegeempfangsstörungen, auf die Amplitude des Multiplexsignals unterschieden werden.

Eine andere Weiterbildung der erfindungsgemäßen Schaltungsanordnung besteht darin, daß die Korrekturschaltung von einer ersten Verzögerungseinrichtung, welche einen Ausgleich der Laufzeit im Hochpaß und gegebenenfalls in der Quadrierschaltung und der Laufzeit beim Vergleich der Ausgangsspannung mit dem zeitlichen Mittelwert bewirkt, einem steuerbaren Umschalter, dem das Steuersignal zuführbar ist, und einer zweiten Verzögerungseinrichtung um eine Periode des Pilottons gebildet wird. Die dadurch erzielte Wiederholung von ungestörten Signalabschnitten hat eine bessere Korrekturwirkung zur Folge als lediglich die Speicherung der vor dem Auftreten der Zündstörung vorhandenen Amplitude.

Eine vorteilhafte Ausgestaltung dieser Weiterbildung sieht vor, daß der steuerbare Schalter ein Umschalter ist, welchem das die erste Verzögerungseinrichtung durchlaufene Multiplexsignal und das die zweite Verzögerungseinrichtung durchlaufene Multiplexsignal zuführbar sind, und daß ein Ausgang des Umschalters den Ausgang der Korrekturschaltung bildet und mit einem Eingang der zweiten Verzögerungseinrichtung verbunden ist.

Bei dieser Ausgestaltung ist ein mehrfaches Wiederholen ungestörter Signalabschnitte möglich, falls Zündstörungen mit längerer Impulsdauer als eine Pilottonperiode auftreten.

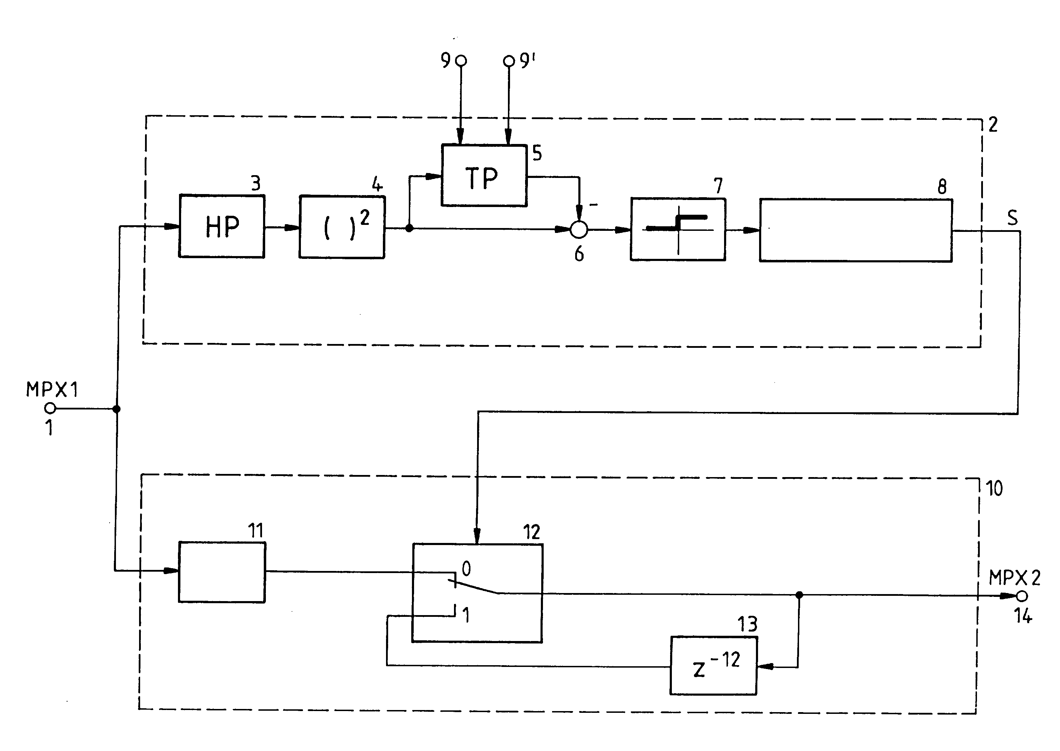

Ein Ausführungsbeispiel der Erfindung ist in der Zeichnung dargestellt und in der nachfolgenden Beschreibung näher erläutert.

Das Ausführungsbeispiel sowie Teile davon sind zwar als Blockschaltbilder dargestellt. Dieses bedeutet jedoch nicht, daß die erfindungsgemäße Schaltungsanordnung auf eine Realisierung mit Hilfe von einzelnen den Blöcken entsprechenden Schaltungen beschränkt ist. Die erfindungsgemäße Schaltungsanordnung ist vielmehr in besonders vorteilhafter Weise mit Hilfe von hochintegrierten Schaltungen realisierbar. Dabei kann beispielsweise ein digitaler Signalprozessor eingesetzt werden, welcher bei geeigneter Programmierung die im Blockschaltbild dargestellten Verarbeitungsschritte durchführt. Die erfindungsgemäße Schaltungsanordnung kann zusammen mit weiteren Schaltungsanordnungen innerhalb einer integrierten Schaltung wesentliche Teile eines Rundfunkempfängers bilden.

Der erfindungsgemäßen Schaltung wird bei 1 von einem nicht dargestellten Demodulator ein digitales Multiplexsignal MPX1 zugeführt. Das digitale Multiplexsignal MPX1 weist eine Abtastrate von 228 kHz auf, also ein Vielfaches der Pilottonfrequenz von 19 kHz. Dieses ganzzahlige Vielfache trägt erheblich zu einer einfachen Realisierung der erfindungsgemäßen Schaltungsanordnung bei. Zur Erkennung von Zündstörungen dient eine Schaltung 2, die aus einem Hochpaß 3, einer Quadrierschaltung 4, einem Tiefpaß 5, einem Subtrahierer 6, einer Schwellwertschaltung 7 und einer Halteschaltung 8 besteht.

Die Schaltung 2 liefert ein Steuersignal S an eine Korrekturschaltung 10, die aus einer ersten Verzögerungseinrichtung 11, einem steuerbaren Umschalter 12 und einer zweiten Verzögerungseinrichtung 13 besteht und an deren Ausgang 14 ein von Zündstörungen befreites Multiplexsignal MPX2 abnehmbar ist.

Der Hochpaß 3 dient dazu, die für Zündstörungen nicht relevanten Komponenten des Multiplexsignals MPX1 zu unterdrücken. Die Quadrierschaltung 4 bewirkt einerseits eine quadratische Bewertung und andererseits eine Gleichrichtung bzw. Betragsbildung des hochpaßgefilterten Multiplexsignals.

Das Ausgangssignal der Quadrierschaltung 4 gelangt einerseits zu einem Tiefpaß 5 und andererseits zu einem der Eingänge des Subtrahierers 6. Mit Hilfe des Tiefpasses, der vorzugsweise ein IIR-Filter erster Ordnung ist und eine Grenzfrequenz im Bereich zwischen 100 Hz und 1000 Hz aufweist, wird ein Mittelwert gebildet. Über Eingänge 9, 9' können Werte eingegeben werden, welche die Verstärkung und die Grenzfrequenz des Tiefpasses bestimmen, wodurch eine Einstellung der Empfindlichkeit der Erkennungsschaltung möglich ist. Dabei wird die Grenzfrequenz bzw. die Anzahl der in die Mittelwertbildung einbezogenen Abtastwerte derart gewählt, daß Änderungen der Amplitude des Ausgangssignals der Quadrierschaltung 4, welche nicht durch Zündstörungen bedingt sind, vom Tiefpaß weitergeleitet werden und somit bei der anschließenden Subtraktion nicht zu einem Ergebnis führen, das eine Korrektur zur Folge hat.

Liegt jedoch eine Zündstörung vor, welcher das Ausgangssignal des Tiefpasses 5 nicht folgen kann, wird die vom Subtrahierer 6 gebildete Differenz so groß, daß die Schwelle in der Schwellwertschaltung 7 überschritten wird und beispielsweise ein logischer Pegel 1 an die Halteschaltung 8 abgegeben wird. Erkennt die Halteschaltung 8 eine 1 am Eingang, wird für eine Anzahl von Abtastwerten eine 1 am Ausgang der Halteschaltung erzeugt. Die Anzahl der Abtastwerte ist derart gewählt, daß die Dauer des Steuersignals S größer ist als die Dauer der vorkommenden Zündstörungen. Bei einem praktisch ausgeführten Ausführungsbeispiel wurden zwölf Abtastwerte gewählt, was etwa 52µs, also einer Periode des Pilottons entspricht. Ein bestimmtes Verhältnis zur Periode des Pilottons ist bei der erfindungsgemäßen Schaltungsanordnung jedoch nicht erforderlich.

Solange das Steuersignal S den Wert 1 annimmt, ist der Zustand am Eingang der Halteschaltung 8 unerheblich. Nach Ablauf der vorgegebenen Zeit wird der Zustand am Eingang der Halteschaltung erneut abgefragt und, falls keine Störung mehr detektiert wird, wechselt der Ausgang der Halteschaltung 8 auf 0.

Das Steuersignal S steuert den Umschalter 12 derart, daß bei einem Pegel 0 des Steuersignals S das dem Eingang 1 zugeführte Multiplexsignal MPX1 dem Ausgang 14 zugeführt wird, wobei lediglich eine Verzögerung 11 zum Ausgleich der Laufzeit in den Schaltungen 3 bis 8 erfolgt. Weist das Steuersignal S den Pegel 1 auf, so wird dem Ausgang 14 über den Umschalter 12 ein bei 13 um eine Periode des Pilottons verzögertes Multiplexsignal zugeleitet. Die durch die Zündstörungen gestörten Abtastwerte des Multiplexsignals MPX1 werden also durch ungestörte, um eine Pilottonperiode vorangegangene Abtastwerte ersetzt, solange am Ausgang der Halteschaltung 8 eine 1 ansteht.

## Patentansprüche

1. Schaltungsanordnung zur Befreiung eines Multiplexsignals von Zündstörungen in einem Rundfunkempfänger, vorzugsweise in einem Autoradio, dadurch gekennzeichnet,
- daß das Multiplexsignal als digitales Signal mit einer Abtastfrequenz von einem Vielfachen der Pilottonfrequenz über einen Hochpaß (3) und eine Quadrierschaltung (4) geleitet wird,
- daß das hochpaßgefilterte und quadrierte Multiplexsignal und ein zeitlicher Mittelwert des hochpaßgefilterten und quadrierten Multiplexsignals miteinander verglichen werden,
- daß bei Abweichungen, die größer als ein vorgegebenes Maß sind, ein Steuersignal vorgegebener Dauer gebildet wird und
- daß das Steuersignal eine Korrekturschaltung (2) derart steuert, daß während des Steuersignals auftretende Abtastwerte des Multiplexsignals durch während der vorangegangenen Periode des Pilottons auftretende Abtastwerte ersetzt werden.

2. Schaltungsanordnung nach Anspruch 1, dadurch gekennzeichnet, daß die Quadrierschaltung aus einer Schaltung zur Betragsbildung besteht.

3. Schaltungsanordnung nach einem der vorhergehenden Ansprüche, dadurch gekennzeichnet, daß der zeitliche Mittelwert mit Hilfe eines Tiefpasses (5) gebildet wird, dessen Grenzfrequenz im Bereich zwischen 100 Hz und 1000 Hz liegt.

4. Schaltungsanordnung nach einem der vorhergehenden Ansprüche, dadurch gekennzeichnet, daß die Korrekturschaltung (2) von einer ersten Verzögerungseinrichtung (11), welche einen Ausgleich der Laufzeit im Hochpaß (3) und gegebenenfalls in der Quadrierschaltung (4) und der Laufzeit beim Vergleich der Ausgangsspannung mit dem zeitlichen Mittelwert bewirkt, einem steuerbaren Umschalter (12), dem das Steuersignal zuführbar ist, und einer zweiten Verzögerungseinrichtung (13) um eine Periode des Pilottons gebildet wird.

5. Schaltungsanordnung nach Anspruch 4, dadurch gekennzeichnet, daß der steuerbare Schalter ein Umschalter (12) ist, welchem das die erste Verzögerungseinrichtung (11) durchlaufene Multiplexsignal und das die zweite Verzögerungseinrichtung (13) durchlaufene Multiplexsignal zuführbar sind, und daß ein Ausgang des Umschalters (12) den Ausgang (14) der Korrekturschaltung (2) bildet und mit einem Eingang der zweiten Verzögerungseinrichtung (13) verbunden ist.

## Claims

1. Circuit arrangement for eliminating ignition interference from a multiplex signal in a radio receiver, preferably in a car radio, characterized
- in that the multiplex signal is routed as a digital signal with a sampling rate of a multiple of the pilot tone frequency via a high-pass filter (3) and a squaring circuit (4),
- in that the high-pass-filtered and squared multiplex signal and an average value over time of the high-pass-filtered and squared multiplex signal are compared with one another,
- in that in the event of deviations which are greater than a predetermined measure, a control signal of predetermined duration is formed, and
- in that the control signal controls a correction circuit (10) in such a way that samples of the multiplex signal which occur during the control signal are replaced by samples occurring during the preceding period of the pilot tone.

2. Circuit arrangement according to Claim 1, characterized in that the squaring circuit comprises a circuit for absolute-value formation.

3. Circuit arrangement according to one of the preceding claims, characterized in that the average value over time is formed with the aid of a low-pass filter (5), whose cut-off frequency lies in the range between 100 Hz and 1000 Hz.

4. Circuit arrangement according to one of the preceding claims, characterized in that the correction circuit (10) is formed by a first delay device (11), which effects compensation of the propagation delay in the high-pass filter (3) and, if appropriate, in the squaring circuit (4) and of the propagation delay during the comparison of the output voltage with the average value over time, a controllable changeover switch (12), to which the control signal can be fed, and a second delay device (13) by one period of the pilot tone.

5. Circuit arrangement according to Claim 4, characterized in that the controllable switch is a changeover switch (12) to which the multiplex signal which has passed through the first delay device (11) and the multiplex signal which has passed through the second delay device (13) can be fed, and in that an output of the changeover switch (12) forms the output (14) of the correction circuit (10) and is connected to an input of the second delay device (13).

## Revendications

1. Circuit pour supprimer les signaux parasites d'allumage d'un signal multiplexé dans un récepteur radiophonique, de préférence un autoradio,
caractérisé en ce que
- le signal multiplexé est conduit, comme signal numérique, avec une fréquence d'échantillonnage correspondant à un multiple de la fréquence du son pilote, par un filtre passe-haut (3) et un circuit de mise au carré (4),
- le signal multiplexé du filtre passe-haut mis au carré et une valeur moyenne dans le temps du signal multiplexé, filtré par un filtre passe-haut et mise au carré sont comparés,
- en cas de différences de la comparaison qui sont supérieures à une valeur prédéterminée, on forme un signal de commande de durée donnée et
- le signal de commande actionne un circuit de correction (2) pour remplacer les valeurs de détection du signal multiplexé produit pendant le signal de commande, par les valeurs de détection provenant de la période précédente du son pilote.

2. Circuit selon la revendication 1,
caractérisé en ce que
le circuit de mise au carré se compose d'un circuit formant une amplitude.

3. Circuit selon l'une quelconque des revendications précédentes,
caractérisé en ce que
la valeur moyenne dans le temps est formée à l'aide d'un filtre passe-bas (5) dont la fréquence limite se situe dans une plage comprise entre 100 Hz et 1000 Hz.

4. Circuit selon l'une quelconque des revendications précédentes,
caractérisé en ce que
le circuit de correction (2) est formé d'un premier moyen de temporisation (11) qui compense le temps de parcours dans le filtre passe-haut (3) et le cas échéant dans le circuit de mise au carré (4), ainsi que le temps de parcours nécessaire à la comparaison de la tension de sortie avec la valeur moyenne dans le temps, d'un commutateur commandé (12) qui reçoit le signal de commande et d'un second moyen de temporisation (13), pour former une période du son pilote.

5. Circuit selon la revendication 4,
caractérisé en ce que
l'interrupteur commandé est un commutateur (12) qui reçoit le signal multiplexé ayant traversé le premier moyen de temporisation (12) et le signal multiplexé ayant traversé le second moyen de temporisation (13), tandis qu'une sortie du commutateur (12) forme la sortie (14) du circuit de correction (2) et est reliée à l'entrée du second moyen de temporisation (13).
